## Europäisches Patentamt
## European Patent Office
## Office européen des brevets

(19)

(11) Numéro de publication: **0 220 989**
**B1**

---

(12) # FASCICULE DE BREVET EUROPEEN

(45) Date de publication du fascicule du brevet:
25.04.90

(51) Int. Cl.⁴: **H01L 29/60**, H01L 21/82,
H01L 27/14

(21) Numéro de dépôt: 86402324.7

(22) Date de dépôt: 16.10.86

---

(54) Dispositif à transfert de charges et procédé de réalisation d'un tel dispositif.

---

(30) Priorité: 22.10.85 FR 8515664

(43) Date de publication de la demande:
06.05.87 Bulletin 87/19

(45) Mention de la délivrance du brevet:
25.04.90 Bulletin 90/17

(84) Etats contractants désignés:
DE GB NL

(56) Documents cités:
RCA REVIEW,
vol. 34, no. 1, mars 1973, pages 164-202, Princeton, N.J.,
US; W.F. KOSONOCKY et al.: "Two-phase
charge-coupled devices with overlapping polysilicon
and aluminium gates"
FUJITSU SCIENTIFIC & TECHNICAL JOURNAL,
vol. 11, no. 3, septembre 1975, pages 79-99, Kawasaki,
JP; H, SEI et al.: "Charge-coupled devices: Part I
fabrication process"
FUJITSU SCIENTIFIC & TECHNICAL JOURNAL,
vol. 11, no. 3, septembre 1975, pages 101-119, Kawasaki,
JP; K. TANIKAWA et al.: "Charge-coupled devices: part
II charge transfer characteristics"

(73) Titulaire: THOMSON-CSF, 51, Esplanade du Général de
Gaulle, F-92800 Puteaux(FR)

(72) Inventeur: Blanchard, Pierre, THOMSON-CSF
SCPI 19, avenue de Messine, F-75008 Paris(FR)
Inventeur: Carquet, Michel, THOMSON-CSF
SCPI 19, avenue de Messine, F-75008 Paris(FR)

(74) Mandataire: Mayeux, Michèle et al, THOMSON-CSF
SCPI, F-92045 PARIS LA DEFENSE CEDEX 67(FR)

---

ACTORUM AG

## Description

L'invention concerne un dispositif à transfert de charges et son procédé de réalisation. Elle concerne plus particulièrement les dispositifs à transfert de charges possédant deux niveaux d'électrodes. Le dispositif à transfert de charges obtenu permet de contrôler le potentiel sur toute la superficie du dispositif. De plus, le procédé de réalisation de ce dispositif à transfert de charges n'exige pas le recouvrement des électrodes des deux niveaux d'électrodes et ne nécessite donc pas une précision de fabrication rigoureuse.

Les dispositifs à transfert de charges actuellement fabriqués doivent de plus en plus obéir aux normes de fabrication des circuits intégrés haute densité (VLSI = Very Large Scale Integration en terminologie anglo-saxonne).

Les dimensions de plus en plus petites des circuits intégrés haute densité imposent non seulement des performances de résolution de photolithographie importantes mais également de très bonnes précisions de positionnement. Pour les dispositifs à transfert de charges à deux niveaux d'électrodes, le positionnement du deuxième niveau d'électrodes par rapport au premier niveau est essentiel pour un fonctionnement correct du dispositif. Cette précision de positionnement est d'autant plus difficile à obtenir qu'on augmente la dimension des plaques utilisées.

Le dispositif à transfert de charges de l'invention permet de pallier cette difficulté de positionnement.

C'est pourquoi l'invention concerne un dispositif à transfert de charges comportant un substrat en semiconducteur dopé et revêtu sur une face d'un matériau isolant, au moins deux électrodes inférieures déposées sur ladite face isolée, séparées par un espace et recouvertes d'un matériau isolant, au moins une électrode supérieure recouvrant une première partie de l'espace, et une partie de l'une desdites électrodes inférieure, ainsi qu'un élément en matériau conducteur faisant partie intégrante de l'électrode supérieure et recouvrant la deuxième partie de l'espace situé entre ladite électrode supérieure et la couche d'isolant de l'autre électrode inférieure.

L'invention concerne également un procédé de réalisation d'un dispositif à transfert de charges comportant les différentes phases successives suivantes :
- une première phase de réalisation d'une couche d'un matériau isolant sur une face d'un substrat en matériau semi-conducteur dopé ;
- une deuxième phase de dépôt sur la couche de matériau isolant d'une première couche d'un matériau conducteur ;
- une troisième phase de gravure dans ladite première couche de matériau conducteur d'au moins deux électrodes inférieures séparées par un espace ;
- une quatrième phase de réalisation sur les électrodes inférieures d'une couche d'un matériau isolant ;
- une cinquième phase de réalisation sur l'ensemble ainsi obtenu d'une couche d'un matériau conducteur ;

- une sixième phase de gravure, dans la couche de matériau conducteur déposée lors de la cinquième phase, d'au moins une électrode supérieure caractérisé en ce que l'électrode supérieure réalisée au cours de la sixième phase recouvre une première partie de l'espace et une partie d'une électrode inférieure, et en ce qu'il comporte une septième phase de réalisation d'une couche de même matériau conducteur que dans la cinquième phase sur l'ensemble des électrodes supérieure et inférieures, suivie d'une huitième phase d'attaque ou d'oxydation de la couche de matériau conducteur de façon à réaliser des éléments en matériau conducteur recouvrant la deuxième partie de l'espace situé entre l'électrode supérieure et l'isolant de l'autre électrode inférieure.

Les différents objets et caractéristiques de l'invention apparaîtront plus clairement dans la description qui va suivre, faite à titre d'exemple, en se reportant aux figures annexées qui représentent :

- les figures 1, 2, 4, 5 et 6, les différentes phases du procédé de réalisation selon l'invention ;
- la figure 3, un dispositif à transfert de charges de type connu ;
- la figure 7, un dispositif à transfert de charges selon l'invention.

Sur les différentes figures, les mêmes éléments portent les mêmes repères.

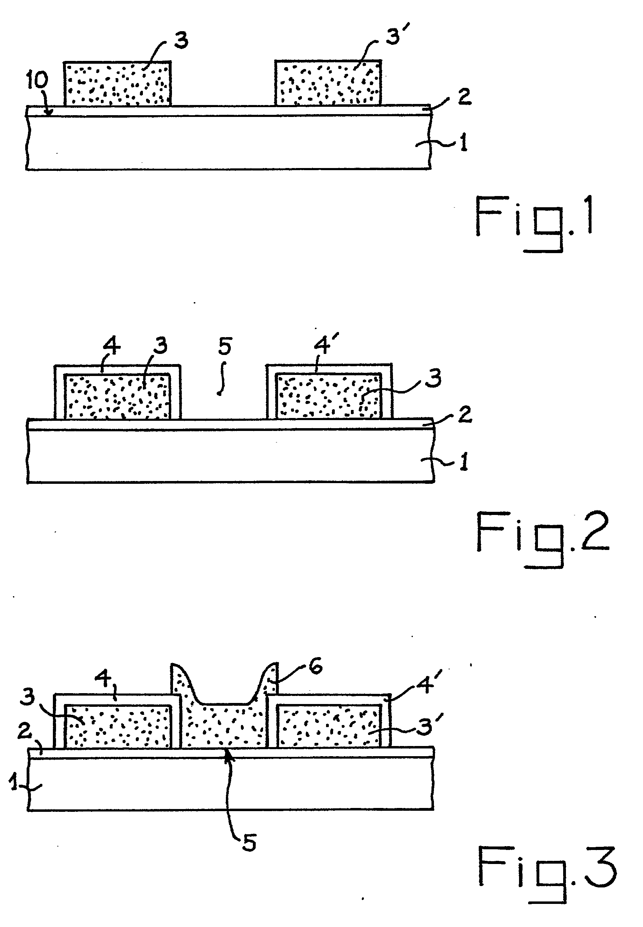

La figure 3 représente un dispositif à transfert de charges connu dans la technique.

Un substrat 1 en matériau semiconducteur, tel que du silicium monocristallin par exemple, est recouvert d'une couche d'un matériau isolant 2 telle qu'une couche d'oxyde.

Sur la couche 2 sont disposées des électrodes 3 et 3' (grilles de stockage par exemple) que nous appellerons électrodes inférieures dans la suite de la description. Ces électrodes sont par exemple en silicium polycristallin. Elles sont recouvertes d'une couche 4 et 4' d'un matériau isolant tel qu'un oxyde. Ces électrodes sont espacées l'une de l'autre et déterminent un espace inter-électrode 5.

Une électrode 6 (ou grille de transfert par exemple), que nous appellerons électrode supérieure dans la suite de la description, recouvre l'espace 5 ainsi qu'une partie des électrodes inférieures 3 et 3' de part et d'autre de l'espace 5.

La réalisation du dispositif à transfert de charges de la figure 3 peut poser des problèmes pour obtenir une électrode supérieure 6 qui recouvre les électrodes inférieures 3 et 3'.

L'invention concerne donc un procédé permettant de réaliser aisément un tel dispositif à transfert de charges.

Lors d'une première phase, on réalise sur une face 10, d'un substrat 1, une couche 2 d'un matériau isolant. Ce matériau peut être un oxyde tel que de la silice.

Sur la couche 2, on dépose ensuite une couche d'un matériau conducteur tel que du silicium polycristallin. Dans cette dernière couche, on grave par photolithogravure, ou tout autre procédé de gravure, des électrodes inférieures 3 et 3'. On obtient ainsi une structure telle que représentée en figure 1 avec des électrodes relativement étroites et peu espacées. C'est ainsi qu'on peut réaliser des électrodes de largeur environ 2,5 µm et espacées d'environ 2,5 µm.

Les électrodes 3 et 3' sont ensuite recouvertes à leur partie supérieure et sur leurs flancs, d'une couche d'un matériau isolant. L'électrode 3 est recouverte d'une couche 4, tandis que l'électrode 3' est recouverte d'une couche 4'. On obtient ainsi une structure telle que représentée en figure 2.

L'ensemble ainsi obtenu est recouvert d'un matériau conducteur tel que du silicium polycristallin. Cette couche est gravée, par photolithogravure par exemple, pour obtenir des électrodes supérieures telle que 6 qui recouvrent les espaces tel que 5 situés entre les électrodes inférieures 3 et 3'. Ce procédé devrait permettre d'obtenir un dispositif à transfert de charges comme représenté en figure 3. Cependant, cela nécessite une grande précision pour l'opération de gravure.

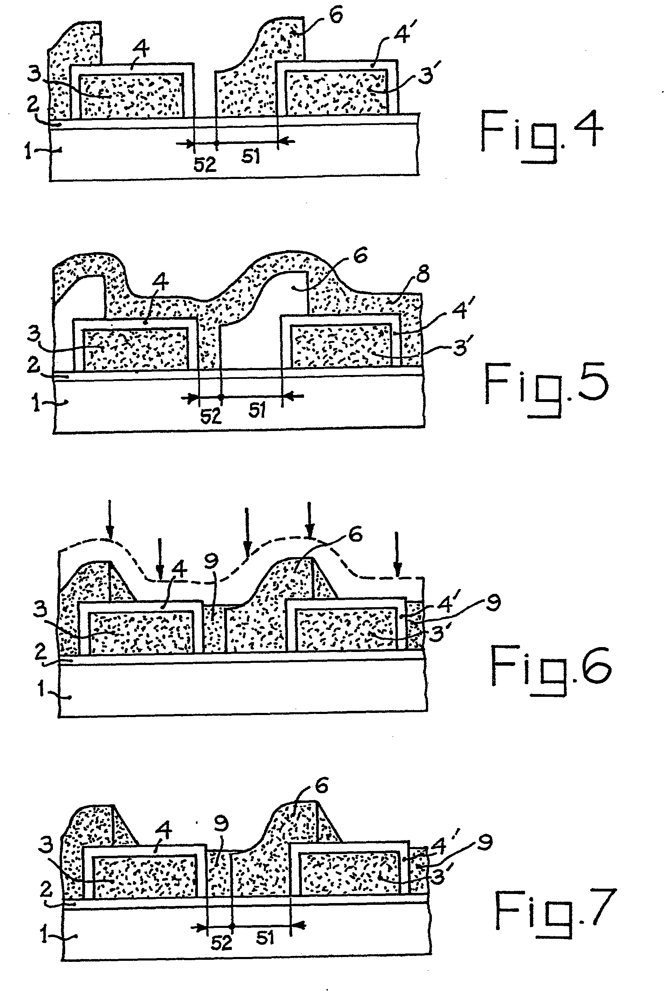

En effet, l'électrode supérieure 6 aura une largeur très peu supérieure à la largeur de l'espace, soit environ 2,5 µm. Une erreur de positionnement peut donc conduire à une réalisation telle que représentée en figure 4 avec un non recouvrement pouvant atteindre une valeur de 0,5 µm.

L'électrode supérieure recouvre la zone 51 de l'espace 5 tandis que la zone 52 n'est pas recouverte et constitue une zone non contrôlée par les électrodes et peut empêcher un transfert correct des charges.

Selon l'invention, on prévoit donc une phase de dépôt d'une couche 8 de même nature que la couche 6 sur l'ensemble de la figure 4, comme cela est représenté en figure 5.

La couche 8 est ensuite attaquée ou oxydée, de façon à séparer les électrodes supérieures 6, tout en assurant le recouvrement total de l'espace inter-électrodes 5 par l'apport d'un élément 9 recouvrant la zone 52 et faisant partie intégrante de l'électrode supérieure 6.

Le procédé de l'invention supprime la nécessité actuellement rencontrée de prévoir un recouvrement afin de pallier à d'éventuels dépositionnements de niveaux d'électrodes. Ceci permet une réduction sensible des dimensions et une diminution importante des capacités parasites dues aux recouvrements.

Dans le cas particulier des dispositifs à transfert de charges fonctionnant suivant le mode deux phases, il est préférable de privilégier les électrodes de stockage par rapport aux électrodes de transfert.

Les anciens procédés, du fait des recouvrements nécessaires entre niveaux d'électrodes conduisent à réaliser des électrodes inférieures 3, 3' plus larges que les électrodes supérieures 6. C'est pourquoi les électrodes inférieures sont affectées au stockage et les électrodes supérieures au transfert des charges.

Dans ce procédé, la largeur des électrodes inférieures 3, 3' tend à se réduire en cours de fabrication (surgravure, oxydation...) ce qui entraîne une augmentation de la largeur des électrodes supérieures 6. Ceci nous conduit à inverser dans ce cas les fonctions affectées aux deux niveaux d'électrodes.

**Revendications**

1. Dispositif à transfert de charges comportant un substrat (1) en semiconducteur dopé et revêtu sur une face (10) d'un matériau isolant (2), au moins deux électrodes inférieures (3, 3') déposées sur ladite face isolée, séparées par un espace (5) et recouvertes d'un matériau isolant (4, 4'), au moins une électrode supérieure (6) recouvrant une première partie (51) de l'espace (5), et une partie de l'une desdites électrodes inférieures (3'), ainsi qu'un élément (9) en matériau conducteur (8) faisant partie intégrante de l'électrode supérieure (6) et recouvrant la deuxième partie (52) de l'espace (5) situé entre l'électrode supérieure et l'isolant de l'autre électrode inférieure (3).

2. Procédé de réalisation d'un dispositif à transfert de charges selon la revendication 1, comportant les différentes phases successives suivantes :
- une première phase de réalisation sur une face (10) d'un substrat (1) en matériau semiconducteur dopé d'une couche d'un matériau isolant (2) ;
- une deuxième phase de réalisation sur la couche de matériau isolant (2) d'une première couche d'un matériau conducteur ;
- une troisième phase de gravure dans ladite première couche de matériau conducteur d'au moins deux électrodes inférieures (3, 3') séparées par un espace (5) ;
- une quatrième phase de réalisation sur les deux électrodes inférieures d'une couche d'un matériau isolant (4, 4') ;
- une cinquième phase de réalisation sur l'ensemble ainsi obtenu d'une couche d'un matériau conducteur ;
- une sixième phase de gravure, dans la couche de matériau conducteur déposée lors de la cinquième phase, d'au moins une électrode supérieure (6) caractérisé en ce que l'électrode supérieure (6) réalisée au cours de la sixième phase recouvre une première partie (51) de l'espace (5) et une partie d'une électrode inférieure (3'), et en ce qu'il comporte une septième phase de réalisation d'une couche (8) de même matériau conducteur que dans la cinquième phase sur l'ensemble des électrodes supérieure et inférieures, suivie d'une huitième phase d'attaque ou d'oxydation de la couche (8) de façon à réaliser des éléments (9) en matériau conducteur recouvrant la deuxième partie (52) de l'espace (5) situé entre l'électrode supérieure (6) et l'isolant de l'autre électrode inférieure (3).

**Claims**

1. A charge transfer device comprising a doped semiconductor substrate (1), one face (10) of which is covered with an insulating material (2), at least two lower electrodes (3, 3') disposed on said insulated face and separated by an interspace (5) and coated with an insulating material (4, 4'), at least one upper electrode (6) covering a first portion (51) of the interspace (5) and a portion of one of said lower electrodes (3'), as well as an element (9) made of conducting material (8), which forms an integral part of the upper electrode (6) and covers the second portion (52) of the interspace (5) between the upper electrode and the insulation of the other one (3) of said lower electrodes.

2. A method for realising a charge transfer device according to claim 1, comprising the following successive different steps:

– a first step of realising a layer (2) of insulating material on a surface (10) of a substrate (1) of doped amorphous semiconductor material,

– a second step of realising a first layer of conducting material on the layer (2) of insulating material,

– a third step of realising at least two lower electrodes (3, 3') separated by an interspace (5) by etching action in said first layer of conducting material,

– a fourth step of realising a layer (4, 4') of insulating material on the two lower electrodes,

– a fifth step of realising a semiconductor layer on the assembly thus obtained,

– a sixth step of realising at least one upper electrode (6) by etching action in the layer of conducting material deposited thereon during the fifth step, characterized in that the upper electrode (6) realised during the sixth step covers a first portion (51) of the interspace (5) and a portion of one of said lower electrodes (3'), and that the method comprises a seventh step of realising a layer (8) of the same conducting material as used in the fifth step, this layer covering the entirety of the upper and lower electrodes, said step being followed by an eighth step of etching or oxidizing the layer (8), such, as to realise elements (9) of conductor material which cover the second portion (52) of the interspace (5) located between the upper electrode (6) and the insulation of the other one (3) of said lower electrodes.


**Patentansprüche**

1. Ladungstransfervorrichtung mit einem dotierten Halbleitersubstrat (1), das auf einer Seite (10) mit einem Isoliermaterial (2) überzogen ist, mit mindestens zwei unteren Elektroden (3, 3') auf der isolierten Seite, die voneinander durch einen Zwischenraum (5) getrennt und mit einem Isoliermaterial (4, 4') bedeckt sind, mit mindestens einer oberen Elektrode (6), die einen ersten Teil (51) des Zwischenraums (5) sowie einen Teil der einen der unteren Elektroden (3') bedeckt, sowie mit einem Element (9) aus leitendem Material (8), das einen integrierenden Bestandteil der oberen Elektrode (6) bildet und den zweiten Teil (52) des Zwischenraums (5) zwischen der oberen Elektrode und der Isolation der anderen unteren Elektrode (3) bedeckt.

2. Verfahren zur Herstellung einer Ladungstransfervorrichtung nach Anspruch 1, das folgende verschiedene Phasen aufweist:

– eine erste Phase der Herstellung einer Schicht aus Isoliermaterial (2) auf einer Seite (10) eines Substrats (1) aus dotiertem, amorphem Halbleitermaterial,

– eine zweite Phase der Herstellung einer ersten Schicht eines leitenden Materials auf der Schicht aus Isoliermaterial (2),

– eine dritte Phase des Herausarbeitens mindestens zweier unterer, durch einen Zwischenraum (5) getrennter Elektroden (3, 3') durch Ätzen aus der ersten Schicht aus leitendem Material,

– eine vierte Phase der Herstellung einer Schicht aus Isoliermaterial (4, 4') auf den beiden unteren Elektroden,

– eine fünfte Phase der Herstellung einer Schicht aus einem leitenden Material auf der so erzeugten Struktur,

– eine sechste Phase des Herausarbeitens mindestens einer oberen Elektrode (6) durch Ätzen aus der in der fünften Phase aufgebrachte Schicht aus leitendem Material, dadurch gekennzeichnet, daß die im Laufe der sechsten Phase herausgearbeitete obere Elektrode (6) einen ersten Teil (51) des Zwischenraums (5) und einen Teil einer unteren Elektrode (3') bedeckt und daß das Verfahren eine siebte Phase der Herstellung einer Schicht (8) auf der oberen Elektrode und den unteren Elektroden aus dem gleichen leitenden Material wie demjenigen der fünften Phase enthält, und daß auf diese Phase eine achte Phase folgt, in der die Schicht (8) chemisch angegriffen oder oxidiert wird, derart, daß Elemente (9) aus leitendem Material gebildet werden, welche den zweiten Teil (52) des Zwischenraums (5) zwischen der oberen Elektrode (6) und der Isolation der anderen unteren Elektrode (3) bedecken.

Fig.1

Fig.2

Fig.3

Fig.4

Fig.5

Fig.6

Fig.7